# EUROPÄISCHE PATENTSCHRIFT

(11) **EP 3 039 437 B1**
(45) Veröffentlichungstag und Bekanntmachung des Hinweises auf die Patenterteilung: **21.02.2018**
(21) Anmeldenummer: 14771821.7
(22) Anmeldetag: 11.09.2014
(51) Int. Cl.: G01R 31/36, H01M 10/48, H02J 7/00, H01M 10/42, H01M 10/16, H01G 11/08, H02J 7/04

(54) **ENERGIESPEICHEREINRICHTUNG**
ENERGY STORAGE DEVICE
DISPOSITIF DE STOCKAGE D'ÉNERGIE

(30) Priorität: 26.09.2013 DE 102013219360
(43) Veröffentlichungstag der Anmeldung: 06.07.2016
(60) Teilanmeldung: 17001635.6
(73) Patentinhaber: Siemens Aktiengesellschaft, 80333 München (DE)
(72) Erfinder: RABBERS, Jacob Johan, 91083 Baiersdorf (DE); SCHRICKER, Barbara, 91058 Erlangen (DE)
(86) Internationale Anmeldenummer: PCT/EP2014/069348
(87) Internationale Veröffentlichungsnummer: WO 2015/043965

(56) Entgegenhaltungen:
- WO-A1-2013/159979
- DE-A1-102007 038 532
- DE-A1-102012 003 100
- JP-A- 2011 086 530
- JP-A- 2011 099 762
- US-A1- 2010 225 325
- US-A1- 2013 045 404
- US-A1- 2013 124 029
- US-A1- 2013 134 908

## Beschreibung

Die Erfindung betrifft eine Energiespeichereinrichtung umfassend eine Batterie mit wenigstens einer Batteriezelle und zwei Polen, zwei Anschlusspunkte, die direkt oder indirekt mit je einem Pol der Batterie verbunden sind, zur Verbindung mit einem externen Stromkreis zum Laden und Entladen der Batterie, und eine Ladezustandsüberwachungseinrichtung zur Bestimmung eines Ladezustandes der Batterie.

Der Ladezustand von elektrochemischen Energiespeichern wie z. B. Lithiumionenbatterien ist eine grundlegende Zustandsgröße, die zur Anzeige des Ladezustands und zur Steuerung des Ladens beziehungsweise Entladens des Speichers benötigt wird. Zum zuverlässigen Betrieb einer Energiespeichereinrichtung muss der Ladezustand hinreichend genau bestimmt sein. In der Praxis stellt aber gerade die Ladezustandsbestimmung, insbesondere bei Batterien mit flacher Kennlinie, wie Batterien auf Basis von z.B.Lithium-Eisen-Phosphat-Zellen, eine besondere Schwierigkeit dar. Eine flache Kennlinie bedeutet, dass für einen Großteil der Ladezustände die Batteriespannung nicht oder nur sehr geringfügig vom Ladezustand abhängt. Soll der Ladezustand der Batterie also durch eine Messung der an der Batterie abfallenden Spannung bestimmt werden, ist aufgrund dieser geringen Abhängigkeit der ermittelte Ladezustand stark fehlerbehaftet. Ungenaue Ladezustandswerte führen im Betrieb dazu, dass entweder nicht die gesamte Speicherkapazität der Batterie genutzt werden kann oder es erfolgen gar störende Notabschaltungen eines mit der Energiespeichereinrichtung betriebenen Systems durch das Batterie-Management-System, wenn Spannungsgrenzen der Batterie erreicht werden.

Bisher werden Ladezustände durch die Kombination zwei sich ergänzender Verfahren ermittelt. Bei einem fließen von Strömen ungleich Null wird die Ladezustandsbestimmung über Ladungs-Zähler realisiert. Dabei wird der Strom, mit dem die Energiespeichereinrichtung geladen beziehungsweise entladen wird, gemessen und über die Zeit integriert. In Kombination mit einem gut definierten Anfangswert wird darüber jeweils der aktuelle Ladezustand berechnet. Ungenauigkeiten in der Strommessung, wie z. B. ein Offset, werden dabei über die Zeit integriert und können zu deutlichen Abweichungen vom tatsächlichen Ladezustand führen.

Zur Korrektur dieser Abweichung wird der Ladezustand deshalb zusätzlich über die Ruhespannung der Energiespeichereinrichtung bestimmt. Der Zusammenhang zwischen Batteriespannung und Ladezustand ist jedoch selbst bei Energiespeichereinrichtungen mit steilen Kennlinien nur dann gegeben, wenn sich die Batterie über einen längeren Zeitraum, beispielsweise 15 Minuten, in Ruhe befindet, das heißt kein Strom in die oder aus der Batterie fließt. Bei Strom ungleich Null weicht die Spannung dagegen je nach Stromrichtung nach oben oder unten von der Ruhespannung ab. Diese Abweichung ist dabei abhängig von zahlreichen Faktoren, insbesondere dem Belassungsprofil und der Temperatur. Die beschriebene Korrektur des Ladezustands kann deshalb nur in Zeiträumen erfolgen, in denen die Energiespeichereinrichtung weder geladen noch entladen wird. Da diese Zeiträume zeitlich beabstandet sind, führen diese Korrekturen in der Regel zu Sprüngen im ermittelten Ladezustand.

Die beschriebenen Korrekturen gestalten sich bei Batterien mit flacher Kennlinie zudem wesentlich schwieriger. Bei solchen Speichern ist die Abhängigkeit der Ruhespannung vom Ladezustand in einem großen Bereich zu gering, um eine zuverlässige Bestimmung des Ladezustands durchführen zu können. Eine Ruhespannungskorrektur, wie oben beschrieben, ist bei diesen Batterien deshalb nicht möglich. Der durch den Ladungs-Zähler berechnete Ladezustand wird daher wie oben beschrieben im Laufe der Zeit immer ungenauer, weshalb der Ladezustand von Zeit zu Zeit kalibriert werden muss. Dies ist beispielsweise möglich, indem die Batterie vollständig geladen und der Ladungszähler auf 100 % gesetzt wird. Während dieses Vorgangs kann die Batterie jedoch typischerweise nicht genutzt werden, da das Laden der Batterie auf 100 % nach einer festgelegten Prozedur erfolgt. Der Vorgang wird deshalb bevorzugt dann ausgeführt, wenn der Speicher nicht einsatzbereit sein muss. Ist eine solche Kalibrierung über einen längeren Zeitraum nicht möglich, ist es möglich, dass der Betrieb der Batterie zur Kalibrierung unterbrochen werden muss.

Die Druckschrift JP 2011 086530 A1 offenbart eine Energiespeichereinrichtung mit einer Batterie und einem Energiespeicherelement, das zu dieser in Serie geschaltet ist. Die Batterie und das Energiespeicherelement bestehen jeweils aus einer Vielzahl von Zellen, die im Fall der Batterie in Serie und im Fall des Energiespeicherelements parallel geschaltet sind. Mit einer Spannungseinrichtung wird die an dem Energiespeicherelement abfallende Spannung gemessen. Diese Spannung korreliert mit einem Ladezustand der Energiespeichereinrichtung. Da der Gesamtstrom der Batterie durch die Energiespeichereinrichtung geleitet wird, kann somit auch der Ladezustand der Batterie bestimmt werden.

DE 10 2012 003 100 A1 offenbart einen Stromintegrator für Hochspannungsbatterien. Ein Energiespeicher für ein Kraftfahrzeug umfasst zumindest eine Zusammenschaltung von zumindest zwei Einzelzellen und zumindest eine zu der zumindest einen Zusammenschaltung in Serie geschaltete Messzelle. Die Variation der Spannung über den Ladezustand ist für die Messzelle größer als für die Einzelzelle. Der zwischen den Kontakten der Batterie fließende Strom wird dabei über die Messzelle in einem Batteriemanagementsystem integriert und ausgewertet. Auf diese Weise kann auf einen Ladezustand des elektrischen Energiespeichers geschlossen werden. Die Messzelle hat eine Ladungskapazität, die ein Vielfaches der Einzelzelle ist. Dabei wird eine Serienschaltung zwischen den Batteriezellen und einem zusätzlichen Energiespeicherelement vorgesehen, weshalb der gesamte durch die Batterie fließende Strom auch durch das zusätzliche Energiespeicherelement, nämlich die Messzelle, geführt werden muss.

US 2010/0225325 A1 offenbart eine Batterie und ein Verfahren zur Bestimmung des Ladezustandes der Batterie. Erste Batteriezellen werden in Serie zu wenigstens einer zweiten Batteriezelle geschaltet, wonach eine an der zweiten Batteriezelle abfallende Spannung gemessen wird.

Die zwischenveröffentlichte WO 2013/159979 A1, welche zum Stand der Technik gemäß Artikel 54(3) EPÜ gehört, offenbart eine Energiespeichereinrichtung gemäß dem Oberbegriff des Anspruchs 1 wobei die Batterie zusätzlich noch eine Aufteilung in zwei Stränge mit jeweils einer Messzelle aufweist und lediglich eine der beiden Messzellen zur Bestimmung des Ladezustandes herangezogen wird. Daraus ergibt sich dass genau die Hälfte des Gesamtstroms dem Energiespeicherelement während des Ladens zugeführt wird. Der Erfindung liegt damit die Aufgabe zugrunde, eine Energiespeichereinrichtung anzugeben, die, insbesondere bei Nutzung einer Batterie mit flacher Ladekurve, eine verbesserte Ladezustandsbestimmung erlaubt.

Die Aufgabe wird erfindungsgemäß durch eine Energiespeichereinrichtung der eingangs genannten Art gelöst, wobei die Energiespeichereinrichtung wenigstens ein zusätzliches Energiespeicherelement, das anders als die Batteriezelle ausgebildet ist, sowie eine Verbindungsschaltung zur direkten oder indirekten Verbindung des Energiespeicherelements mit wenigstens einem der Pole der Batterie und wenigstens einem Anschlusspunkt umfasst, wobei die Verbindungsschaltung derart ausgebildet und kontaktiert ist, dass das Energiespeicherelement mit einem Energiespeicherelementstrom geladen und/oder entladen wird, der in einem vorgegebenen Verhältnis zum Gesamtstrom durch die Energiespeichereinrichtung steht, wobei eine Spannungsmesseinrichtung das zusätzliche Energiespeicherelement zur Messung der am Energiespeicherelement abfallenden Energiespeicherspannung kontaktiert und die Ladezustandsüberwachungseinrichtung zur Bestimmung des Ladezustands der Batterie in Abhängigkeit zumindest der Energiespeicherspannung ausgebildet ist.

Der Erfindung liegt die Idee zugrunde, den Ladezustand nicht direkt durch eine Spannungsmessung an der Batterie zu messen, sondern die Spannung an einem weiteren Energiespeicherelement zu messen, das mit einem Energiespeicherelementstrom geladen und/oder entladen wird, der in einem vorgegeben Verhältnis zum Gesamtstrom durch die Energiespeichereinrichtung steht. Dieses Vorgehen ist insbesondere vorteilhaft, wenn eine Batterie genutzt wird, die eine relativ flache Kennlinie hat, wodurch, wie eingangs beschrieben, eine Bestimmung der Batterieladung durch Messung der an der Batterie abfallenden Spannung nicht mit ausreichender Genauigkeit möglich ist. Zudem ist vorteilhaft, dass, wenn das weitere Energiespeicherelement nur mit einem relativ kleinen Bruchteil des Gesamtstroms ge- beziehungsweise entladen wird, die am Energiespeicherelement abfallende Spannung deutlich weniger von der Belastung der Energiespeichereinrichtung abhängig sein kann, als die an der Batterie abfallende Spannung. Damit kann es in der erfindungsgemäßen Energiespeichereinrichtung möglich sein, den Ladezustand der Batterie auch während der Belastung der Energiespeichereinrichtung zu ermitteln.

Vor Nutzung der erfindungsgemäßen Energiespeichereinrichtung können die Batterie und das Energiespeicherelement auf einen definierten Ladezustand gebracht werden. Es ist dabei besonders vorteilhaft, wenn das Verhältnis des Energiespeicherelementstroms zum Gesamtstrom so gewählt ist, dass das Energiespeicherelement über den gesamten möglichen Ladungsbereich der Batterie parallel ge- beziehungsweise entladen werden kann. Daher sollte die in dem Energiespeicherelement speicherbare Ladung wenigstens so groß gewählt sein, dass das Verhältnis der in dem Energiespeicherelement speicherbaren Ladung zur in der Batterie speicherbaren Ladung wenigstens so groß ist wie das Verhältnis des Energiespeicherelementstroms zu dem Strom mit dem die Batterie ge- beziehungsweise entladen wird. Das Energiespeicherelement ist mit der Batterie und wenigstens einem der Anschlusspunkte über eine Verbindungsschaltung verbunden. Dabei kann die Verbindungsschaltung wenigstens einen Pol des Energiespeicherelements sowie den wenigstens einen Pol der Batterie und wenigstens einen Anschlusspunkt entweder direkt leitfähig kontaktieren, oder die Verbindung kann indirekt über wenigstens ein weiteres Bauelement erfolgen.

Dabei kann der Energiespeicherelementstrom ein Teil des Gesamtstroms sein. Die Verbindungsschaltung kann also derart ausgebildet und kontaktiert sein, dass der Gesamtstrom zu definierten Bruchteilen der Batterie und dem Energiespeicherelement entstammt und/oder dieser zugeführt wird. Alternativ ist es jedoch auch möglich, dass die Batterie und das Energiespeicherelement in separaten Stromkreisen angeordnet sind und ein Bauteil der Verbindungsschaltung diese Stromkreise derart koppelt, dass eine Übertragung elektrischer Energie zwischen den Schaltkreisen möglich ist und diese Energieübertragung abhängig vom Gesamtstrom derart gesteuert wird, dass der Energiespeicherelementstrom in einem vorgegebenen Verhältnis zum Gesamtstrom steht.

Die Verbindungsschaltung kann im einfachsten Fall jeweils eine leitfähige Verbindung, beispielsweise durch Leiterbahnen, zwischen einem ersten der Pole des Energiespeicherelements und einem der Pole der Batterie und zwischen einem zweiten der Pole des Energiespeicherelements und einem der Anschlusspunkte umfassen. Die Verbindungsschaltung kann jedoch auch aktive oder passive Bauteile umfassen. Erfindungsgemäß umfasst die Verbindungsschaltung wenigstens einen ersten, einen zweiten und einen dritten Verbindungskontakt und ist mit dem ersten Verbindungskontakt und dem zweiten Verbindungskontakt seriell zwischen einem der Pole der Batterie und dem mit diesem verbundenen Anschlusspunkt geschaltet und mit dem dritten Verbindungskontakt das Energiespeicherelement direkt oder indirekt kontaktiert. Durch die serielle Verbindung zwischen Batterie und Verbindungsschaltung, bei der beispielsweise der erste Verbindungskontakt mit einem der Pole der Batterie und der zweite Verbindungskontakt mit dem zugeordneten Anschlusspunkt verbunden ist, wird erreicht, dass der gesamte Stromfluss von der oder zu der Batterie durch die Verbindungsschaltung geführt ist. Der Stromfluss zwischen dem ersten und dem zweiten Verbindungskontakt entspricht also dem Stromfluss zur beziehungsweise von der Batterie.

Der dritte Verbindungskontakt kontaktiert direkt oder indirekt einen der Pole des Energiespeicherelements. Dabei ist es möglich, dass der dritte Verbindungskontakt und der zweite oder ein vierter Verbindungskontakt jeweils einen der Pole des Energiespeicherelements direkt oder indirekt kontaktieren. Alternativ kann der dritte Verbindungskontakt auch einen der Pole des Energiespeicherelements direkt oder indirekt kontaktieren und der weitere Pol des Energiespeicherelements kann direkt oder indirekt mit dem weiteren Pol der Batterie verbunden sein. In beiden Ausführungsformen kann der Energiespeicherelementstrom dem Strom entsprechen, der durch den dritten Verbindungskontakt fließt. Der Stromfluss durch den dritten Verbindungskontakt kann dabei direkt durch die Verbindungsschaltung vorgegeben sein. Dabei soll der Stromfluss durch den dritten Verbindungskontakt und damit der Energiespeicherelementstrom erfindungsgemäß derart vorgegeben sein, dass er zum Gesamtstrom durch die Energiespeichereinrichtung proportional ist.

Um dies zu erreichen kann die Verbindungsschaltung eine Strommesseinrichtung zur Messung des Batteriestromflusses zwischen dem ersten und dem zweiten Verbindungskontakt umfassen. Die Strommesseinrichtung kann insbesondere einen zwischen dem ersten und dem zweiten Verbindungskontakt geschalteten Widerstand und eine Spannungsmesseinrichtung zur Messung der Spannung, die an diesem Widerstand abfällt, umfassen. Die Spannungsmesseinrichtung kann in Form eines Instrumentenverstärkers ausgebildet sein, dem am ersten seiner Eingänge die batterieseitig am Widerstand anliegende Spannung und am zweiten seiner Eingänge die anschlusspunktseitig am Widerstand anliegende Spannung zugeführt wird. Damit wird am Ausgang des Instrumentenverstärkers ein Spannungssignal bereitgestellt, das proportional zum Stromfluss zwischen dem ersten und zweiten Verbindungskontakt ist. Dieses Spannungssignal kann dann zur Steuerung weiterer Elemente der Verbindungsschaltung genutzt werden.

Die Verbindungsschaltung kann zudem eine Stromquelle und/oder eine Stromsenke zwischen dem dritten Verbindungskontakt und dem zweiten oder vierten Verbindungskontakt aufweisen, wobei die Stromquelle und/oder die Stromsenke in Abhängigkeit des Batteriestromflusses steuerbar sind. Dies ist besonders einfach möglich, wenn, wie oben beschrieben, in der Verbindungsschaltung ein Spannungssignal vorliegt, das proportional zum Stromfluss zwischen dem ersten und dem zweiten Verbindungskontakt ist. Die Stromquelle beziehungsweise Stromsenke kann dann insbesondere als spannungsgesteuerte Stromquelle oder Stromsenke ausgebildet sein. Hierbei kann insbesondere eine zwei Quadranten beziehungsweise vier Quadranten Stromquelle genutzt werden, die sowohl als Stromquelle dienen kann, also einer Schaltung Energie zur Verfügung stellt, als auch als Stromsenke, also aus der Schaltung Energie aufnimmt.

Dabei kann in der erfindungsgemäßen Energiespeichereinrichtung die Energieversorgung der zwei beziehungsweise vier Quadranten Stromquelle insbesondere durch die Energiespeichereinrichtung selbst erfolgen. Dabei kann die Versorgung durch Versorgungsleitungen erfolgen, die direkt mit den Anschlusspunkten verbunden sind. In diesem Fall trägt der Energiespeicherelementstrom, der durch die zwei beziehungsweise vier Quadranten Stromquelle dem Energiespeicherelement zugeführt oder entzogen wird, zum Gesamtstrom bei und es wird erreicht, dass der Gesamtstrom zu definierten Bruchteilen der Batterie und dem Energiespeicherelement entstammt und/oder diesem zugeführt wird.

Alternativ kann die Verbindungsschaltung eine Strommesseinrichtung zur Messung des Batteriestromflusses zwischen dem ersten und dem zweiten Verbindungskontakt und ein Stromsteuerungselement, das den Stromfluss durch das Stromsteuerungselement in Abhängigkeit des Batteriestromflusses bestimmt, zwischen dem dritten Verbindungskontakt und dem zweiten oder einem vierten Verbindungskontakt umfassen. Damit wird der Stromfluss durch den dritten Verbindungskontakt und damit der Energiespeicherelementstrom wiederum in Abhängigkeit des Stromflusses zwischen dem ersten und zweiten Verbindungskontakt und damit in Abhängigkeit des Stromflusses in die oder aus der Batterie bestimmt.

Stromsteuerungselemente wie Transistoren können einen Stromfluss typischerweise nur steuern, wenn am Stromsteuerungselement eine Spannung abfällt. Steuert das Stromsteuerelement also direkt den Stromfluss zwischen dem dritten und zweiten Verbindungskontakt oder sind der vierte Verbindungskontakt und der zweite Verbindungskontakt niederohmig verbunden, muss im beschriebenen Fall der Spannungsabfall zwischen dem dritten Verbindungskontakt und dem zweiten Verbindungskontakt größer sein als der Spannungsabfall zwischen dem ersten Verbindungskontakt und dem zweiten Verbindungskontakt. Werden keine zusätzlichen Bauteil wie Gleichspannungswandler oder ähnliches genutzt, müsste in diesem Fall die Batteriespannung bei einem Entladen der Batterie kleiner sein als die am Energiespeicherelement abfallende Spannung und beim Laden der Batterie größer als die am Energiespeicherelement abfallende Spannung. Um die Verbindungsschaltung sowohl zum Laden als zum Entladen der Batterie nutzen zu können und dennoch sicherzustellen, dass der Energiespeicherelementstrom in einem vorgegebenen Verhältnis zum Gesamtstrom steht, ist es daher vorteilhaft, ergänzend zwischen dem zweiten oder vierten Verbindungskontakt und dem dritten Verbindungskontakt eine weitere Strommesseinrichtung und zwischen dem zweiten Verbindungskontakt und dem ersten Verbindungskontakt ein weiteres Stromsteuerelement vorzusehen. Zudem ist es vorteilhaft, wenn die Batterie und das Energiespeicherelement derart gewählt sind, dass in allen genutzten Ladezuständen entweder die an der Batterie abfallende Spannung größer ist als die am Energiespeicherelement abfallende Spannung oder umgekehrt. Eine größere Flexibilität bei der Auswahl der Batterie und des Energiespeicherelements kann erreicht werden, indem zwischen Batterie oder Energiespeicherelement und dem jeweils zugeordneten Stromsteuerungselement ein Gleichspannungswandler angeordnet wird, um die entsprechende Spannung zu erhöhen oder abzusenken.

Dabei kann das Stromsteuerungselement und/oder die Strommesseinrichtung wenigstens einen Transistor umfassen. So verhalten sich Transistoren, wenn sie nicht gesättigt betrieben werden, ausgangsseitig wie eine Stromquelle, die in Abhängigkeit einer Basis- beziehungsweise Gatterspannung gesteuert wird. Gleichzeitig ist es jedoch auch, insbesondere durch eine Rückkopplung der Basis beziehungsweise des Gatters, auf den Kollektor beziehungsweise zum Source-Anschluss möglich einen Transistor als Strommesseinrichtung zu nutzen. Dabei können insbesondere baugleiche Transistoren als Stromsteuerungselement und Strommesseinrichtung genutzt werden. Die baugleichen Transistoren können insbesondere beide Teile eines integrierten Schaltkreises sein.

Die Verbindungsschaltung kann insbesondere als Stromspiegel ausgebildet sein, wobei ein Stromfluss zwischen dem dritten Verbindungskontakt und dem zweiten oder dem vierten Verbindungskontakt durch einen Stromfluss zwischen dem ersten Verbindungskontakt und dem zweiten Verbindungskontakt bestimmt ist. Wie bereits erläutert ist es vorteilhaft, wenn die Verbindungsschaltung beim Laden und Entladen der Batterie genutzt werden soll, zwei Stromspiegel vorzusehen, wobei einer der Stromspiegel in Abhängigkeit des Batteriestroms den Energiespeicherelementstrom bestimmt und der andere der Stromspiegel in Abhängigkeit des Energiespeicherelementstroms den Batteriestrom. Dabei kann der erste Verbindungskontakt mit einem ersten Pol der Batterie, der dritte Verbindungskontakt mit dem ersten Pol des Energiespeicherelements und der zweite Pol der Batterie mit dem zweiten Pol des Energiespeicherelements verbunden sein.

Alternativ kann die Verbindungsschaltung ein Gleichspannungswandler sein oder einen Gleichspannungswandler umfassen. Dabei kann der Gleichspannungswandler insbesondere zwischen einer Spannung, die zwischen dem ersten und dem zweiten Verbindungskontakt abfällt, und einer Spannung, die zwischen dem dritten Verbindungskontakt und dem zweiten oder vierten Verbindungskontakt abfällt, wandeln. Insbesondere kann das Energiespeicherelement dabei direkt oder indirekt mit dem dritten und dem vierten oder dem zweiten Verbindungskontakt verbunden sein, wobei insbesondere zwischen wenigstens einem der Pole des Energiespeicherelements und einem der Verbindungskontakte ein zusätzlicher Widerstand angeordnet sein kann. Durch den zusätzlichen Widerstand ist es dabei insbesondere möglich, dass der Gleichspannungswandler als Stromquelle fungiert. Die zwischen dem ersten und zweiten Verbindungskontakt abfallende Spannung ist proportional zum Stromfluss. Damit kann durch Nutzung eines Gleichspannungswandlers in der Verbindungsschaltung ein festes Stromverhältnis zwischen dem zur Batterie oder aus der Batterie fließenden Strom und dem Energiespeicherelementstrom erreicht werden, wodurch der Energiespeicherelementstrom in einem vorgegebenen Verhältnis zum Gesamtstrom steht. Die Nutzung eines Gleichstromwandlers ist dabei besonders vorteilhaft, da die am Energiespeicherelement abfallende Spannung unabhängig von der Batteriespannung gewählt werden kann, da die Spannungen durch ein passendes Taktverhältnis des Gleichspannungswandlers angeglichen werden können. Zudem ist ein Strom- oder Energietransport bei einem Gleichspannungswandler in beide Richtungen möglich. Damit kann eine Verbindungsschaltung mit einem einzelnen Gleichspannungswandler sowohl beim Laden als auch beim Entladen der Energiespeichereinrichtung genutzt werden.

Es ist grundsätzlich möglich, dass die Verbindungsschaltung die Batterie galvanisch von dem Energiespeicherelement trennt. In diesem Fall kann das Energiespeicherelement insbesondere in einem separaten Stromkreis von der Batterie angeordnet sein. Die Energieübertragung zwischen den Stromkreisen kann dann insbesondere durch eine Wechselrichtung des Stroms beispielsweise in einem galvanisch trennenden Gleichspannungswandler erfolgen. Nicht erfindungsgemäß kann das Energiespeicherelement in Serie zur Batterie geschaltet sein. Durch eine Serienschaltung von Energiespeicherelement und Batterie ist sichergestellt, dass der Energiespeicherelementstrom gleich zum Strom ist, der der Batterie zugeführt oder entnommen wird. Typischerweise hat das Energiespeicherelement eine geringere Kapazität als die Batterie. Deshalb können bei einer Serienschaltung von Energiespeicherelement und Batterie zusätzliche Maßnahmen getroffen werden, um die volle Kapazität der Batterie weiterhin nutzen zu können.

Dabei ist es, wie auch in den anderen Ausführungsformen möglich, dass mehrere Energiespeicherelemente parallel zueinander geschaltet sind. Insbesondere können Energiespeicherelemente mit einem relativ geringen Spannungsabfall genutzt werden. Durch die Parallelschaltung der Speicherelemente wird eine relativ große Kapazität erreicht. Gleichzeitig kann die Gesamtspannung durch eine Batterie mit einer ähnlichen Kapazität, die jedoch eine größere Batteriespannung hat, bereitgestellt werden.

Speziell für den Fall der Serienschaltung von Energiespeicherelement und Batterie ist es jedoch auch möglich einen Bypass-Pfad für den Strom zu bilden, über den ein definierter Teil des Stroms an dem Energiespeicherelement vorbei direkt zu oder von der Batterie geführt wird. Hierzu können alle beschriebenen Verbindungsschaltungen genutzt werden, die derart ausgebildet und kontaktiert sind, dass sie einen Gesamtstrom zu definierten Bruchteilen der Batterie und der Energiespeichereinheit zuführen oder entnehmen. Statt einer Aufteilung des Gesamtstroms auf die Energiespeichereinheit und die Batterie erfolgt nun jedoch eine Aufteilung des Gesamtstroms auf eine Serienschaltung von Energiespeichereinheit und Batterie einerseits und nur die Batterie andererseits.

Es ist möglich, dass die Ladezustandsüberwachungseinrichtung ausgebildet ist, mehrere zeitlich beabstandete Spannungswerte und/oder ermittelte Ladezustände der Batterie und/oder des Energiespeicherelements zu speichern und bei der Berechnung des Ladezustands der Batterie zu berücksichtigen. Dies ist vorteilhaft, da es abhängig vom Ladezustand der Batterie und/oder des Energiespeicherelements zu geringfügigen Abweichungen vom vorgegebenen Verhältnis zwischen Gesamtstrom und Energiespeicherelementstrom kommen kann. Werden zeitlich vorangehende Ladezustände der Batterie und/oder des Energiespeicherelements erfasst und wurden einmalig Kalibrierdaten für die Energiespeichereinrichtung oder eine baugleiche Energiespeichereinrichtung erfasst und in der Ladezustandsüberwachungseinrichtung hinterlegt, so kann auch bei ladezustandsabhängigen Abweichungen vom vorgegebenen Verhältnis der tatsächliche Ladezustand rekonstruiert werden. Dabei ist es möglich, dass die Korrektur des Ladezustands rein rechnerisch erfolgt, womit ein korrekter Ladezustand der Batterie ermittelt wird, jedoch die Ladezustände von Batterie und Energiespeicherelement über die Zeit auseinander driften können, weshalb in gewissen Zeitabständen eine Kalibrierung der Energiespeichereinrichtungen durchgeführt werden sollte. Es ist jedoch auch möglich, dass die Energiespeichereinrichtung eine Ladungstransfervorrichtung, insbesondere einen Gleichspannungswandler, umfasst, der bei einer Feststellung eines Auseinanderdriftens der Ladezustände von Batterie und Energiespeicherelement eine vorgegebene Strommenge von der Batterie in das Energiespeicherelement oder umgekehrt transferiert.

Zudem ist es möglich, dass die Energiespeichereinrichtung eine Strommesseinrichtung zur Messung einer Ist-Stromgröße für den Stromfluss durch die Energiespeichereinrichtung und/oder die Batterie und/oder das Energiespeicherelement umfasst, wobei die Ladezustandsüberwachungseinrichtung zur Berücksichtigung der Ist-Stromgröße und/oder zur Speicherung der Ist-Stromgröße und zur Berücksichtigung zeitlich vorangehender Ist-Stromgrößen bei der Berechnung des Ladezustands der Batterie und/oder des Energiespeicherelements ausgebildet ist. Dies ist vorteilhaft, da sich abhängig von der Belastung der Energiespeichereinrichtung, das tatsächliche Verhältnis zwischen Gesamtstrom und Energiespeicherelementstrom vom vorgegebenen Verhältnis unterscheiden kann. Durch die Berücksichtigung der Ist-Stromgröße beziehungsweise der zeitlich vorangegangenen Ist-Stromgrößen, können solche Abweichungen bei der Berechnung des Ladezustands der Batterie berücksichtigt werden. Wie vorangehend beschrieben, kann auch in diesem Fall bei Ermittlung eines Auseinanderdriftens der Ladezustände von Batterie und Energiespeicherelement eine definierte Strommenge von der Batterie in die Energiespeichereinrichtung oder umgekehrt übertragen werden.

In der erfindungsgemäßen Energiespeichereinrichtung ist es insbesondere vorteilhaft, wenn die am Energiespeicherelement abfallende Spannung für zumindest einen Bereich der Ladezustände des Energiespeicherelements eine stärkere Abhängigkeit von dem Ladezustand des Energiespeicherelements aufweist, als die Abhängigkeit der an der Batterie abfallenden Spannung von dem Ladezustand der Batterie im äquivalenten Ladebereich der Batterie. Wie eingangs erläutert, ist es insbesondere problematisch, den Ladezustand von Batterien mit flacher Kennlinie durch Spannungsmessung zu ermitteln. Soll eine solche Batterie genutzt werden, kann in der erfindungsgemäßen Energiespeichereinrichtung vorteilhaft ein Energiespeicherelement mit einer steileren Kennlinie genutzt werden. Die Wahl des zusätzlichen Energiespeicherelements kann flexibel getroffen werden, da es bei einer entsprechend ausgebildeten Verbindungsschaltung sowohl die am Energiespeicherelement abfallende Spannung als auch die Kapazität des Energiespeicherelements nahezu wählbar sind. Um eine langfristig gute Übereinstimmung des Ladezustands des Energiespeicherelements und der Batterie zu erreichen ist es vorteilhaft, wenn ein Energiespeicherelement mit geringer Selbstentladung gewählt wird.

Das Energiespeicherelement kann insbesondere eine elektrochemische Speicherzelle oder ein Kondensator oder ein Superkondensator sein. Bei dem Superkondensator kann es sich insbesondere um einen Doppelschichtkondensator, einen Hybridkondensator oder einen Pseudokondensator handeln.

Weitere Vorteile und Einzelheiten der Erfindung ergeben sich aus den folgenden Ausführungsbeispielen sowie den zugehörigen Zeichnungen. Dabei zeigen:
- FIG 1: schematisch ein Ausführungsbeispiel einer erfindungsgemäßen Energiespeichereinrichtung,
- FIG 2: schematisch ein weiteres Ausführungsbeispiel einer erfindungsgemäßen Energiespeichereinrichtung,
- FIG 3: eine mögliche Ausführungsform der in FIG 2 gezeigten Verbindungsschaltung,
- FIG 4: eine weiter mögliche Ausführungsform der in FIG 2 gezeigten Verbindungsschaltung,
- FIG 5: eine mögliche Ausführungsform der in FIG 1 gezeigten Verbindungsschaltung,
- FIG 6: eine weitere mögliche Ausführungsform der in FIG 1 gezeigten Verbindungsschaltung,
- FIG 7: ein drittes Ausführungsbeispiel einer erfindungsgemäßen Energiespeichereinrichtung, und
- FIG 8: ein viertes Ausführungsbeispiel einer erfindungsgemäßen Energiespeichereinrichtung.

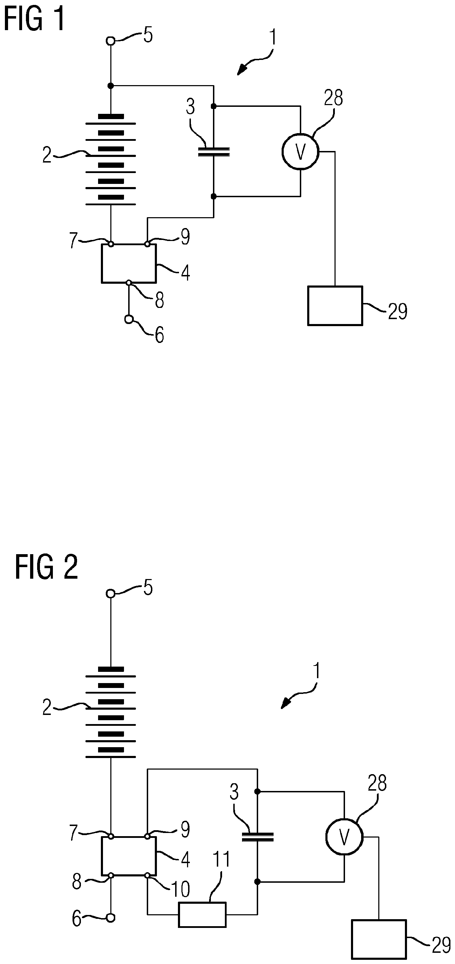

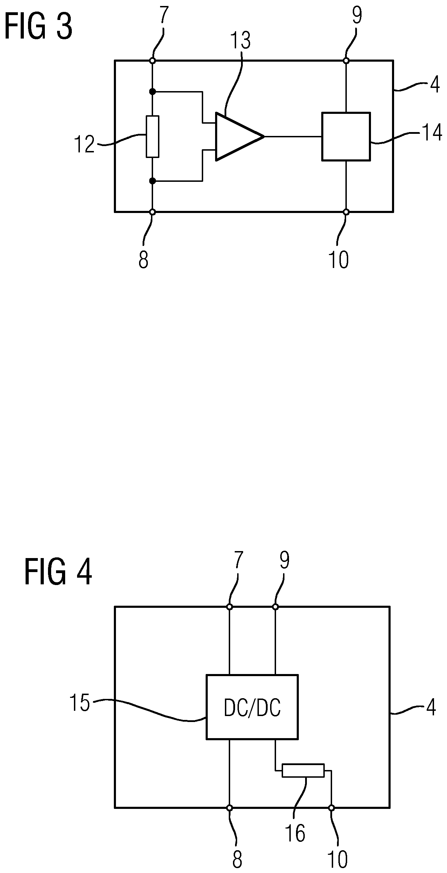

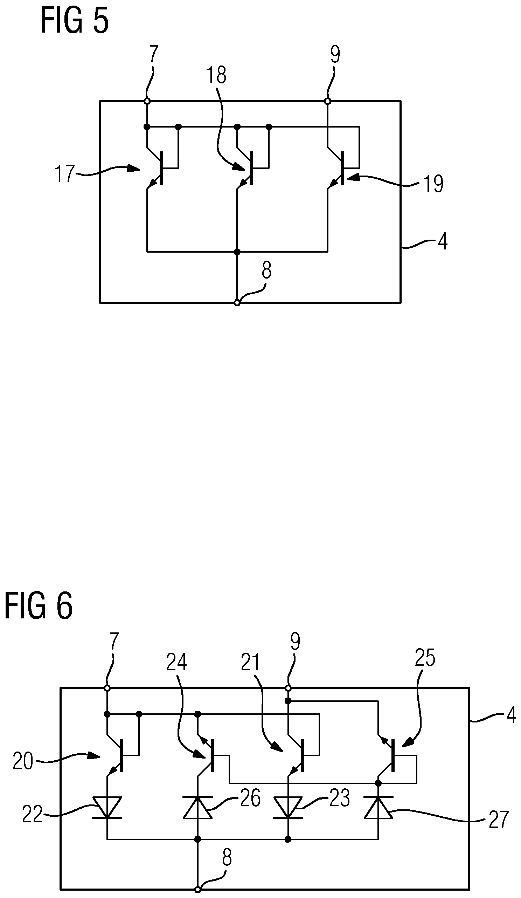

FIG 1 zeigt eine Energiespeichereinrichtung 1 die eine Batterie 2 sowie ein zusätzliches Energiespeicherelement 3 umfasst, das als Doppelschichtkondensator ausgebildet ist. Die Energiespeichereinrichtung 1 weist einen ersten Anschlusspunkt 5 und einen zweiten Anschlusspunkt 6 zur Verbindung mit einem Stromkreis auf. Die Verbindung zwischen der Batterie 2 und dem zusätzlichen Energiespeicherelement 3 folgt auf der Seite des Minuspols der Batterie 2 direkt und auf der Seite des Pluspols der Batterie 2 durch die Verbindungsschaltung 4. Die Verbindungsschaltung 4 weist einen ersten Verbindungskontakt 7, einen zweiten Verbindungskontakt 8 und einen dritten Verbindungskontakt 9 auf. Der erste Verbindungskontakt 7 ist direkt mit dem Minuspol der Batterie 2 verbunden, der zweite Verbindungskontakt 8 ist direkt mit dem zweiten Anschlusspunkt 6 verbunden und der dritte Verbindungskontakt 9 kontaktiert das Energiespeicherelement 3. Die Verbindungsschaltung 4 ist dabei derart ausgebildet, dass der Gesamtstrom, der über die Anschlusspunkte 5, 6 fließt und damit auch über den Verbindungskontakt 8, in einem vorgegebenen Verhältnis zwischen der Batterie 2 und der Energiespeichereinrichtung 3 und damit zwischen den Verbindungskontakten 7 und 9 aufgeteilt wird. Mögliche Ausführungsformen der Verbindungsschaltung 4 werden mit Bezug auf Fig. 5 und Fig. 6 erläutert. Die in Fig. 3 und Fig. 4 erläuterten Ausführungsformen einer Verbindungsschaltung können zudem derart weitergebildet werden, dass sie auch in der in Fig. 1 gezeigten Energiespeichereinrichtung 1 genutzt werden können.

Die an der Energiespeichereinrichtung 3 abfallende Spannung wird durch die Spannungsmesseinrichtung 28 gemessen und der ermittelte Spannungswert wird durch die Ladezustandsüberwachungseinrichtung 29 ausgelesen. Die Spannung, die an dem Energiespeicherelement 3 abfällt, ist abhängig vom Ladezustand des Energiespeicherelements 3. Da der Energiespeicherelementstrom, der das Energiespeicherelement 3 lädt beziehungsweise entlädt, proportional zu dem Strom ist der die Batterie lädt beziehungsweise entlädt, korrelieren der Ladezustand des Energiespeicherelements 3 und damit auch die an dem Energiespeicherelement 3 abfallende Spannung mit dem Ladezustand der Batterie 2. Anhand eines vorausbestimmten Kalibrierdatensatzes kann die Ladezustandsüberwachungseinrichtung 29 also aus der durch die Spannungsmesseinrichtung 28 gemessenen Spannung den Ladezustand der Batterie 2 berechnen.

FIG 2 zeigt ein weiteres Ausführungsbeispiel einer Energiespeichereinrichtung. Die Energiespeichereinrichtung 1 unterscheidet sich von der in Fig. 1 gezeigten Energiespeichereinrichtung durch die Art der Anbindung des Energiespeicherelements 3. Die Pole des Energiespeicherelements 3 sind in FIG 2 direkt mit dem dritten Verbindungskontakt 9 der Verbindungseinrichtung 4 beziehungsweise indirekt über den Widerstand 11 mit dem vierten Verbindungskontakt 10 der Verbindungsschaltung 4 verbunden. Die Verbindungsschaltung 4 ist derart ausgebildet, dass der Stromfluss zwischen dem ersten und dem zweiten Verbindungskontakt 7 und 8 in einem festen Verhältnis zum Stromfluss zwischen dem dritten und dem vierten Verbindungskontakt 9, 10 steht. Dabei kann die Verbindungseinrichtung 4 so ausgebildet sein, dass der erste und zweite Verbindungskontakt 7, 8 von dem dritten und vierten Verbindungskontakt 9 und 10 galvanisch getrennt sind. In diesem Fall ist kein Gleichstromfluss zwischen den Anschlusspunkten 5, 6 und dem Energiespeicherelement 3 möglich. Insbesondere durch ein vorübergehendes Wechselrichten ist aber dennoch eine Energieübertragung zwischen dem Energiespeicherelement 3 und einer an den Anschlusspunkten 5, 6 verbundenen Schaltung möglich. Mögliche Ausführungsformen für die Verbindungsschaltung 4 werden mit Bezug auf Fig. 3 und Fig. 4 erläutert.

FIG. 3 zeigt eine Ausführungsform der Verbindungsschaltung 4 von FIG 2, die auch in der in FIG 1 gezeigten Ausführungsform der Energiespeichereinrichtung 1 genutzt werden kann, indem der zweite und der vierte Verbindungskontakt 8, 10 verbunden werden. Zwischen dem ersten und dem zweiten Verbindungskontakt 7, 8 ist ein niederohmiger Widerstand 12 angeordnet, an dem abhängig von dem zwischen dem ersten Verbindungskontakt 7 und dem zweiten Verbindungskontakt 8 fließenden Strom eine Spannung abfällt. Die an dem Widerstand 12 abfallende Spannung wird durch den Instrumentenverstärker 13 verstärkt und als Steuerspannung der Stromquelle 14 zugeführt. Die Stromquelle 14 ist eine vier Quadranten Stromquelle, die unabhängig von der zwischen dem dritten Verbindungskontakt 9 und dem vierten Verbindungskontakt 10 abfallenden Spannung, abhängig von der Ausgangsspannung des Instrumentenverstärkers 13, einen definierten Stromfluss zwischen dem dritten Verbindungskontakt 9 und dem vierten Verbindungskontakt 10 herbeiführen kann. Abhängig von der relativen Richtung von Strom und Spannung an der vier Quadranten Stromquelle 14 dient die vier Quadranten Stromquelle 14 dabei als Stromquelle oder Stromsenke. Die Energieversorgung der vier Quadranten Stromquelle 14 erfolgt durch nicht gezeigte Versorgungsleitungen, die die Anschlusspunkte 5, 6 kontaktieren. Daher wird die zum Betrieb der vier Quadranten Stromquelle notwendige Energie der Energiespeichereinrichtung entnommen und bei einem Betrieb als Stromsenke die zurückgewonnene Energie in die Energiespeichereinrichtung eingespeist. Dadurch kann erreicht werden, dass der Gesamtstrom zu definierten Bruchteilen der Batterie und der Energiespeichereinheit entstammt und/oder dieser zugeführt wird.

FIG 4 zeigt eine weitere Ausführungsform der Verbindungsschaltung 4, die in der in FIG 2 gezeigten Schaltung 1 genutzt werden kann. Auch für diese Verbindungsschaltung 4 ist eine Nutzung in der in FIG 1 gezeigten Schaltung 1 möglich, wenn der zweite Verbindungskontakt 8 mit dem vierten Verbindungskontakt 10 verbunden wird. Die Verbindungsschaltung 4 umfasst einen Gleichspannungswandler 15, der als Eingangsspannung die Spannung zwischen dem ersten Verbindungskontakt 7 und dem zweiten Verbindungskontakt 8 abgreift. Die Ausgangsspannung des Gleichspannungswandlers 15 ist einseitig direkt mit dem dritten Verbindungskontakt 9 verbunden, der Bezugspunkt für die am Verbindungskontakt 9 ausgegebene Spannung wird über einen Widerstand 1 mit dem vierten Verbindungskontakt 10 verbunden. Durch den verglichen mit einer erwarteten Impedanzänderung der weiteren Schaltung hochohmigen Widerstand 16 kann der Gleichspannungswandler 15 als Stromquelle betrachtet werden. Die Höhe des abgegebenen Stroms korreliert hierbei mit der zwischen dem ersten Verbindungskontakt 7 und dem zweiten Verbindungskontakt 8 abfallenden Spannung. Diese ist jedoch abhängig vom durch den Gleichspannungswandler 15 geführten Strom. Damit ist auch der Strom zwischen dem dritten Verbindungskontakt 9 und dem vierten Verbindungskontakt 10 abhängig vom Strom zwischen dem ersten Verbindungskontakt 7 und dem zweiten Verbindungskontakt 8. Es kann dabei auch vorteilhaft sein, zwischen dem ersten Verbindungskontakt 7 und dem zweiten Verbindungskontakt 8, parallel zum Gleichspannungswandler 15, einen zusätzlichen Widerstand vorzusehen, um den Realteil der Impedanz zwischen dem ersten Verbindungskontakt 7 und dem zweiten Verbindungskontakt 8 anzupassen.

FIG 5 zeigt eine mögliche Ausführungsform der in FIG 1 gezeigten Verbindungsschaltung 4. Die Verbindungsschaltung 4 ist als Stromspiegel aufgebaut, der drei Transistoren 17, 18, 19 umfasst. Dabei ist die Basis aller Transistoren 17, 18, 19 sowie der Kollektor der Transistoren 17, 18 mit dem ersten Verbindungskontakt 7 verbunden und der Kollektor des Transistors 19 mit dem dritten Verbindungskontakt 9. Die Emitter aller Transistoren 17, 18, 19 speisen den zweiten Verbindungskontakt 8. Durch die Rückkopplungsschaltung zwischen Basis und Kollektor der Transistoren 17, 18 fungieren diese als Stromspannungswandler, wobei die Spannung zwischen Basis und Emitter jeweils vom Strom abhängt, der die Transistoren 17, 18 durchfließt. Diese Spannung entspricht der Spannung an der Basis des Transistors 19, wodurch der Transistor 19 als programmierbare Stromquelle betrieben wird, die von genau so viel Strom durchflossen wird, wie jede der Transistoren 17 und 18. Die gezeigte Schaltung dient also als Stromspiegel, wobei der Stromfluss zwischen dem dritten Verbindungskontakt 9 und dem zweiten Verbindungskontakt 8 genau halb so groß ist wie der Stromfluss zwischen dem ersten Verbindungskontakt 7 und dem zweiten Verbindungskontakt 8. Durch das Schalten weiterer Transistoren, die wie Transistoren 17, 18 geschaltet sind, kann das Teilungsverhältnis angepasst werden. Dabei ist zu beachten, dass die Spiegelung des Stroms der Transistoren 17, 18 auf den Transistor 19 nur dann erfolgen kann, wenn am Transistor 19 zwischen Kollektor und Basis eine Spannung abfällt. Daher muss die Spannung am dritten Verbindungskontakt 9 stets höher sein als die Spannung am ersten Verbindungskontakt 7. Es ist daher notwendig, die Batterie und das Energiespeicherelement entsprechend zu wählen oder alternativ einen zusätzlichen Gleichspannungswandler zu nutzen, um diese Randbedingung stets zu erfüllen.

Die in FIG 5 gezeigte Verbindungsschaltung 4 stellt ein vorgegebenes Verhältnis zwischen Energiespeicherelementstrom und Gesamtstrom nur beim Entladen der Batterie sicher. In FIG 6 ist eine weitere Verbindungsschaltung 4 gezeigt, die das vorgegebene Verhältnis zwischen Energiespeicherelementstrom und Gesamtstrom sowohl beim Laden auch als beim Entladen sicherstellt. In der gezeigten Verbindungsschaltung 4 ist der Strom durch den zweiten Verbindungskontakt 8 zu gleichen Teilen aus den Strömen am ersten Verbindungskontakt 7 und am dritten Verbindungskontakt 9 zusammengesetzt. Durch die parallele Nutzung mehrerer gleichgeschalteter Transistoren, wie sie in Fig. 5 gezeigt ist, kann dieses Teilungsverhältnis jedoch angepasst werden. In der Verbindungsschaltung 4 sind die Transistoren 20 und 21 als Stromspiegel geschaltet, wie bereits mit Bezug auf Fig. 5 erläutert. In Serie mit den Transistoren 20 und 21 sind die Dioden 22 und 23 geschaltet, um zu verhindern, dass die entsprechenden Schaltungszweige bei einem Laden der Energiespeichereinrichtung 1 genutzt werden. Transistoren 24 und 25 bilden einen Stromspiegel für den Fall, dass die Spannung am zweiten Verbindungskontakt 8 höher ist als die Spannung am ersten Verbindungskontakt 7 beziehungsweise am dritten Verbindungskontakt 9. Diese Situation tritt genau dann auf, wenn die Energiespeichereinrichtung geladen wird. Die Schaltungszweige der Transistoren 24, 25 umfassen zudem die Dioden 26, 27 um sicherzustellen, dass die entsprechenden Schaltungszweige nur bei einem Laden der Energiespeichereinrichtung 1 genutzt werden.

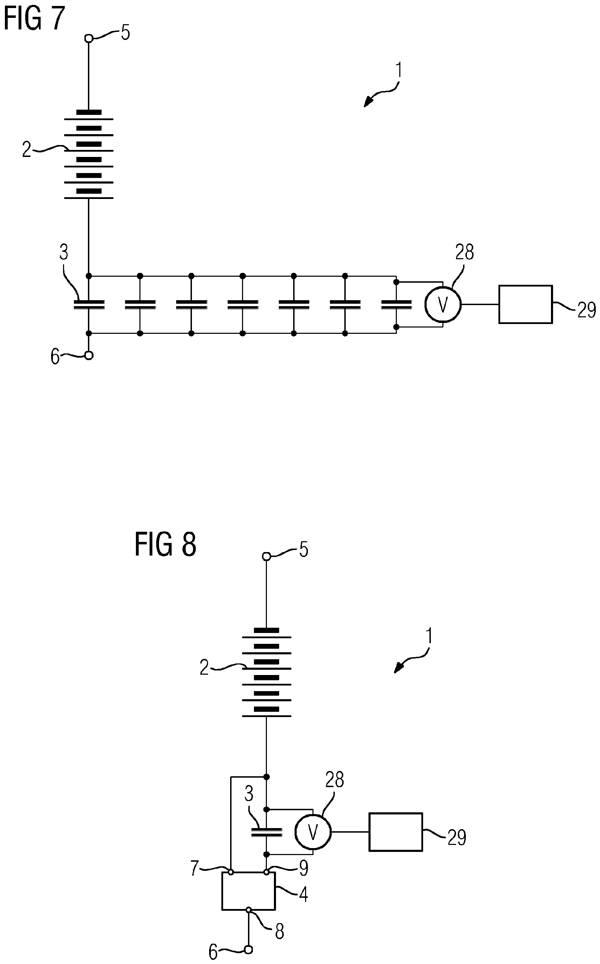

FIG 7 zeigt ein weiteres, nicht zur vorliegenden Erfindung gehörendes, Ausführungsbeispiel einer Energiespeichereinrichtung, die neben der Batterie 2 mehrere Energiespeicherelemente 3 umfasst, die parallel zueinander und in Serie zur Batterie 2 geschaltet sind. Durch die Parallelschaltung der Energiespeicherelemente 3 wird eine höhere Gesamtkapazität der Energiespeicherelemente 3 erreicht. Damit muss jedes der Energiespeicherelemente 3 nur einen Bruchteil des Stroms bereitstellen, der durch die Energiespeichereinrichtung fließt. In diesem Ausführungsbeispiel fließt zwar durch die Gesamtzahl der Energiespeicherelemente ein Strom, der gleich dem Gesamtstrom ist, durch jedes einzelne der Energiespeicherelement jedoch nur ein Energiespeicherelementstrom der gleich dem Gesamtstrom geteilt durch die Anzahl der Energiespeicherelemente ist. Die Messung der an den Energiespeicherelementen 3 abfallenden Spannung durch die Spannungsmesseinrichtung 28 und die Berechnung des Ladezustands der Batterie 2 durch die Ladezustandsüberwachungseinrichtung 29 erfolgt wie zu Fig. 1 erläutert.

FIG 8 zeigt ein weiteres Ausführungsbeispiel einer Energiespeichereinrichtung, bei der der Ladezustand der Batterie durch Messen eines Spannungsabfalls an einem Energiespeicherelement 3 bestimmt wird. In der in FIG 8 gezeigten Energiespeichereinrichtung 1 sind das Energiespeicherelement 3 und die Batterien in Serie geschaltet. Der Gesamtstrom, der durch die Energiespeichereinrichtung fließt, fließt am Verbindungskontakt 8 in die oder aus der Verbindungsschaltung 4. Die Verbindungsschaltung 4 teilt den Strom nun in einem vorgegebenen Verhältnis zwischen dem ersten Verbindungskontakt 7 und dem dritten Verbindungskontakt 9 auf. Der Strom der durch den dritten Verbindungskontakt 9 fließt lädt beziehungsweise entlädt das Energiespeicherelement 3. Gleichzeitig lädt oder entlädt dieser Strom jedoch auch die Batterie 2. Der Strom der durch den ersten Verbindungskontakt 7 fließt wird an dem Energiespeicherelement 3 vorbeigeführt und lädt oder entlädt ausschließlich die Batterie 2. Da die Verbindungsschaltung 4 in Fig. 8 die gleiche Aufgabe erfüllt wie die Verbindungsschaltung 4 in FIG 1, kann die Verbindungsschaltung auch identisch aufgebaut sein.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Energiespeichereinrichtung umfassend eine Batterie (2) mit wenigstens einer Batteriezelle und zwei Polen, zwei Anschlusspunkte (5, 6), die direkt oder indirekt mit je einem Pol der Batterie (2) verbunden sind, zur Verbindung mit einem externen Stromkreis zum Laden und Entladen der Batterie (2), und eine Ladezustandsüberwachungseinrichtung (29) zur Bestimmung eines Ladezustandes der Batterie (2), wobei die Energiespeichereinrichtung (1) wenigstens ein zusätzliches Energiespeicherelement (3), das anders als die Batteriezelle ausgebildet ist, sowie eine Verbindungsschaltung (4) zur direkten oder indirekten Verbindung des Energiespeicherelements (3) mit wenigstens einem der Pole der Batterie (2) und wenigstens einem Anschlusspunkt (5, 6) umfasst, wobei die Verbindungsschaltung (4) derart ausgebildet und kontaktiert ist, dass das Energiespeicherelement (3) mit einem Energiespeicherelementstrom geladen und/oder entladen wird, der in einem vorgegebenen Verhältnis zum Gesamtstrom durch die Energiespeichereinrichtung (1) steht, wobei eine Spannungsmesseinrichtung (28) das zusätzliche Energiespeicherelement (3) zur Messung der am Energiespeicherelement (3) abfallenden Energiespeicherspannung kontaktiert und die Ladezustandsüberwachungseinrichtung (29) zur Bestimmung des Ladezustands der Batterie (2) in Abhängigkeit zumindest der Energiespeicherspannung ausgebildet ist, **dadurch gekennzeichnet dass** die Verbindungsschaltung (4) wenigstens einen ersten, einen zweiten und einen dritten Verbindungskontakt (7, 8, 9) umfasst und mit dem ersten Verbindungskontakt (7) und dem zweiten Verbindungskontakt (8) seriell zwischen einem der Pole der Batterie (2) und dem mit diesem verbundenen Anschlusspunkt (6) geschaltet ist und mit dem dritten Verbindungskontakt (9) das Energiespeicherelement (3) direkt oder indirekt kontaktiert.

2. Energiespeichereinrichtung nach Anspruch 1,
**dadurch gekennzeichnet, dass** die Verbindungsschaltung (4) derart ausgebildet und kontaktiert ist, dass der Gesamtstrom zu definierten Bruchteilen der Batterie (2) und dem Energiespeicherelement (3) entstammt und/oder diesen zugeführt wird.

3. Energiespeichereinrichtung nach Anspruch 1 oder 2, **dadurch gekennzeichnet, dass** der dritte Verbindungskontakt (9) und der zweite oder ein vierter Verbindungskontakt (8, 10) jeweils einen der Pole des Energiespeicherelementes (3) direkt oder indirekt kontaktieren.

4. Energiespeichereinrichtung nach einem der vorangehenden Ansprüche, **dadurch gekennzeichnet, dass** die Verbindungsschaltung (4) eine Strommesseinrichtung zur Messung des Batteriestromflusses zwischen dem ersten und dem zweiten Verbindungskontakt (7, 8) umfasst.

5. Energiespeichereinrichtung nach Anspruch 4, **dadurch gekennzeichnet, dass** die Verbindungsschaltung (4) eine Stromquelle (14) und/oder eine Stromsenke zwischen dem dritten Verbindungskontakt (9) und dem zweiten oder vierten Verbindungskontakt (8, 10) aufweist, wobei die Stromquelle (14) und/oder die Stromsenke in Abhängigkeit des Batteriestromflusses steuerbar sind.

6. Energiespeichereinrichtung nach einem der vorangehenden Ansprüche, **dadurch gekennzeichnet, dass** die Verbindungsschaltung (4) eine Strommesseinrichtung zur Messung des Batteriestromflusses zwischen dem ersten und dem zweiten Verbindungskontakt (7, 8) und ein Stromsteuerungselement, das den Stromfluss durch das Stromsteuerungselement in Abhängigkeit des Batteriestromflusses bestimmt, zwischen dem dritten Verbindungskontakt (9) und dem zweiten oder einem vierten Verbindungskontakt (8, 10) umfasst.

7. Energiespeichereinrichtung nach Anspruch 6, **dadurch gekennzeichnet, dass** das Stromsteuerungselement und/oder die Strommesseinrichtung wenigstens einen Transistor (17, 18, 19, 20, 21, 24, 25) umfassen.

8. Energiespeichereinrichtung nach Anspruch 6 oder 7 **dadurch gekennzeichnet, dass** die Verbindungsschaltung (4) als Stromspiegel ausgebildet ist, wobei ein Stromfluss zwischen dem dritten Verbindungskontakt (9) und dem zweiten oder dem vierten Verbindungskontakt (8, 10) durch einen Stromfluss zwischen dem ersten Verbindungskontakt (7) und dem zweiten Verbindungskontakt (8) bestimmt ist.

9. Energiespeichereinrichtung nach einem der Ansprüche 1 bis 3, **dadurch gekennzeichnet, dass** die Verbindungsschaltung (4) ein Gleichspannungswandler (15) ist oder einen Gleichspannungswandler (15) umfasst.

10. Energiespeichereinrichtung nach einem der vorangehenden Ansprüche, **dadurch gekennzeichnet, dass** die Verbindungsschaltung (4) die Batterie (2) galvanisch von dem Energiespeicherelement (3) trennt.

11. Energiespeichereinrichtung nach einem der vorangehenden Ansprüche, **dadurch gekennzeichnet, dass** mehrere Energiespeicherelemente (3) parallel zueinander geschaltet sind.

12. Energiespeichereinrichtung nach einem der vorangehenden Ansprüche, **dadurch gekennzeichnet, dass** die Ladezustandsüberwachungseinrichtung (29) ausgebildet ist, mehrere zeitlich beabstandete Spannungsmesswerte und/oder ermittelte Ladezustände der Batterie (2) und/oder des Energiespeicherelementes (3) zu speichern und bei der Berechnung des Ladezustandes der Batterie (2) zu berücksichtigen.

13. Energiespeichereinrichtung nach einem der vorangehenden Ansprüche, **dadurch gekennzeichnet, dass** sie eine Strommesseinrichtung zur Messung einer Ist-Stromgröße für den Stromfluss durch die Energiespeichereinrichtung (1) und/oder die Batterie (2) und/oder das Energiespeicherelement (3) umfasst, wobei die Ladezustandsüberwachungseinrichtung (29) zur Berücksichtigung der Ist-Stromgröße und/oder zur Speicherung von Ist-Stromgrößen und zur Berücksichtigung zeitlich vorangehender Ist-Stromgrößen bei der Berechnung des Ladezustandes der Batterie (2) und/oder des Energiespeicherelementes (3) ausgebildet ist.

14. Energiespeichereinrichtung nach einem der vorangehenden Ansprüche, **dadurch gekennzeichnet, dass** die am Energiespeicherelement (3) abfallende Spannung für zumindest einen Bereich der Ladezustände des Energiespeicherelements (3) eine stärkere Abhängigkeit von dem Ladezustand des Energiespeicherelements (3) aufweist, als die Abhängigkeit der an der Batterie (2) abfallenden Spannung von dem Ladezustand der Batterie (2) im äquivalenten Ladebereich der Batterie (2).

15. Energiespeichereinrichtung nach einem der vorangehenden Ansprüche, **dadurch gekennzeichnet, dass** das weitere Energiespeicherelement (3) eine elektrochemische Speicherzelle oder ein Kondensator oder ein Superkondensator ist.

16. Energiespeichereinrichtung nach Anspruch 15, **dadurch gekennzeichnet, dass** der Superkondensator ein Doppelschichtkondensator, ein Hybridkondensator oder ein Pseudokondensator ist.

## Claims

1. Energy storage device comprising a battery (2) having at least one battery cell and two poles, two terminal points (5, 6), which are connected directly or indirectly to a respective pole of the battery (2), for connection to an external electrical circuit for charging and discharging the battery (2), and a state of charge monitoring device (29) for determining a state of charge of the battery (2), wherein the energy storage device (1) comprises at least one additional energy storage element (3) embodied differently than the battery cell, and a connection circuit (4) for directly or indirectly connecting the energy storage element (3) to at least one of the poles of the battery (2) and at least one terminal point (5, 6), where the connection circuit (4) is embodied and contacted in such a way that the energy storage element (3) is charged and/or discharged with an energy storage element current that is in a predefined ratio to the total current through the energy storage device (1), wherein a voltage measuring device (28) contacts the additional energy storage element (3) in order to measure the energy storage voltage dropped across the energy storage element (3) and the state of charge monitoring device (29) is designed for determining the state of charge of the battery (2) depending at least on the energy storage voltage, **characterized in that** the connection circuit (4) comprises at least one first, one second and one third connection contact (7, 8, 9) and with the first connection contact (7) and the second connection contact (8) is connected in series between one of the poles of the battery (2) and the terminal point (6) connected to it and with the third connection contact (9) directly or indirectly contacts the energy storage element (3).

2. Energy storage device according to Claim 1,
**characterized in that** the connection circuit (4) is embodied and contacted in such a way that the total current in defined fractions originates from the battery (2) and the energy storage element (3) and/or is fed to them.

3. Energy storage device according to Claim 1 or 2, **characterized in that** the third connection contact (9) and the second or a fourth connection contact (8, 10) directly or indirectly contact in each case one of the poles of the energy storage element (3).

4. Energy storage device according to any of the preceding claims, **characterized in that** the connection circuit (4) comprises a current measuring device for measuring a battery current flow between the first and second connection contacts (7, 8).

5. Energy storage device according to Claim 4, **characterized in that** the connection circuit (4) has a current source (14) and/or a current sink between the third connection contact (9) and the second or fourth connection contact (8, 10), wherein the current source (14) and/or the current sink are/is controllable depending on the battery current flow.

6. Energy storage device according to any of the preceding claims, **characterized in that** the connection circuit (4) comprises a current measuring device for measuring the battery current flow between the first and second connection contacts (7, 8) and a current control element, which determines the current flow through the current control element depending on the battery current flow, between the third connection contact (9) and the second or a fourth connection contact (8, 10).

7. Energy storage device according to Claim 6, **characterized in that** the current control element and/or the current measuring device comprise(s) at least one transistor (17, 18, 19, 20, 21, 24, 25).

8. Energy storage device according to Claim 6 or 7, **characterized in that** the connection circuit (4) is embodied as a current mirror, wherein a current flow between the third connection contact (9) and the second or the fourth connection contact (8, 10) is determined by a current flow between the first connection contact (7) and the second connection contact (8).

9. Energy storage device according to any of Claims 1 to 3, **characterized in that** the connection circuit (4) is a DC voltage converter (15) or comprises a DC voltage converter (15).

10. Energy storage device according to any of the preceding claims, **characterized in that** the connection circuit (4) galvanically isolates the battery (2) from the energy storage element (3).

11. Energy storage device according to any of the preceding claims, **characterized in that** a plurality of energy storage elements (3) are connected in parallel with one another.

12. Energy storage device according to any of the preceding claims, **characterized in that** the state of charge monitoring device (29) is designed to store a plurality of temporally spaced voltage measurement values and/or determined states of charge of the battery (2) and/or of the energy storage element (3) and to take them into account in the calculation of the state of charge of the battery (2).

13. Energy storage device according to any of the preceding claims, **characterized in that** it comprises a current measuring device for measuring an actual current variable for the current flow through the energy storage device (1) and/or the battery (2) and/or the energy storage element (3), wherein the state of charge monitoring device (29) is designed for taking account of the actual current variable and/or for storing actual current variables and for taking account of temporally preceding actual current variables in the calculation of the state of charge of the battery (2) and/or of the energy storage element (3).

14. Energy storage device according to any of the preceding claims, **characterized in that** the voltage dropped across the energy storage element (3) for at least one range of the states of charge of the energy storage element (3) has a greater dependence on the state of charge of the energy storage element (3) than the dependence of the voltage dropped across the battery (2) on the state of charge of the battery (2) in the equivalent charging range of the battery (2).

15. Energy storage device according to any of the preceding claims, **characterized in that** the further energy storage element (3) is an electrochemical storage cell or a capacitor or a supercapacitor.

16. Energy storage device according to Claim 15, **characterized in that** the supercapacitor is a double-layer capacitor, a hybrid capacitor or a pseudocapacitor.

## Revendications

1. Dispositif d'accumulation d'énergie, comprenant une batterie (2) ayant au moins un élément de batterie et deux pôles, deux points (5, 6) de connexion, qui sont reliés directement ou indirectement à respectivement un pôle de la batterie (2) pour la liaison à un circuit de courant extérieur, afin de charger et décharger la batterie (2), et un dispositif (29) de contrôle de l'état de charge pour déterminer un état de charge de la batterie (2), le dispositif (1) d'accumulation d'énergie comprenant au moins un élément (3) supplémentaire d'accumulation d'énergie, constitué autrement que l'élément de batterie, ainsi qu'un circuit (4) de liaison pour la liaison directe ou indirecte de l'élément (3) d'accumulation d'énergie à au moins l'un des pôles de la batterie (2) et au moins un point (5, 6) de connexion, le circuit (4) de liaison étant constitué et mis en contact, de manière à charger et/ou à décharger l'élément (2) d'accumulation d'énergie par un courant d'élément d'accumulation d'énergie, qui est dans un rapport donné à l'avance au courant total passant dans le dispositif (1) d'accumulation d'énergie, dans lequel un dispositif (28) de mesure de la tension est en contact avec l'élément (3) supplémentaire d'accumulation d'énergie pour mesurer la tension de l'accumulateur d'énergie chutant aux bornes de l'élément (3) d'accumulation d'énergie et le dispositif (29) de contrôle de l'état de charge est constitué pour déterminer l'état de charge de la batterie (2) en fonction d'au moins la tension de l'accumulateur d'énergie, **caractérisé en ce que** le circuit (4) de liaison comprend au moins un premier, un deuxième et un troisième contacts (7, 8, 9) de liaison et, par le premier contact (7) de liaison et le deuxième contact (8) de liaison, l'élément (3) d'accumulation d'énergie est monté en série entre l'un des pôles de la batterie (2) et le point (6) de connexion, qui lui est relié, et l'élément (3) d'accumulation d'énergie est en contact directement ou indirectement avec le troisième contact (9) de liaison.

2. Dispositif d'accumulation d'énergie suivant la revendication 1,
**caractérisé en ce que** le circuit (4) de liaison est constitué et mis en contact, de manière à ce que le courant global provienne, pour des fractions définies, de la batterie (2) et de l'élément (3) d'accumulation d'énergie et/ou y soit envoyé.

3. Dispositif d'accumulation d'énergie suivant la revendication 1 ou 2,
**caractérisé en ce que** le troisième contact (9) de liaison et le deuxième ou un quatrième contacts (8, 10) de liaison sont en contact directement ou indirectement respectivement avec l'un des pôles de l'élément (3) d'accumulation d'énergie.

4. Dispositif d'accumulation d'énergie suivant l'une des revendications précédentes,
**caractérisé en ce que** le circuit (4) de liaison comprend un dispositif de mesure du courant pour mesurer le flux du courant de batterie entre le premier et le deuxième contacts (7, 8) de liaison.

5. Dispositif d'accumulation d'énergie suivant la revendication 4, **caractérisé en ce que** le circuit (4) de liaison a une source (14) de courant et/ou un puits de courant entre le troisième contact (9) de liaison et le deuxième ou le quatrième contact (8, 10) de liaison, la source (14) de courant et/ou le puits de courant pouvant être commandé en fonction du flux de courant de batterie.

6. Dispositif d'accumulation d'énergie suivant l'une des revendications précédentes,
**caractérisé en ce que** le circuit (4) de liaison comprend un dispositif de mesure du courant pour mesurer le flux de courant de batterie entre le premier et le deuxième contacts (7, 8) de liaison et un élément de commande de courant, qui détermine le flux de courant passant dans l'élément de commande du courant en fonction du flux de courant de batterie, entre le troisième contact (9) de liaison et le deuxième ou un quatrième contact (8, 10) de liaison.

7. Dispositif d'accumulation d'énergie suivant la revendication 6,
**caractérisé en ce que** les éléments de commande de courant et/ou le dispositif de mesure du courant comprennent au moins un transistor (17, 18, 19, 20, 21, 24, 25).

8. Dispositif d'accumulation d'énergie suivant la revendication 6 ou 7,
**caractérisé en ce que** le circuit (4) de liaison est constitué sous la forme d'un miroir de courant, un flux de courant, entre le troisième contact (9) de liaison et le deuxième ou le quatrième contact (8, 10) de liaison, étant déterminé par un flux de courant entre le premier contact (7) de liaison et le deuxième contact (9) de liaison.

9. Dispositif d'accumulation d'énergie suivant l'une des revendications 1 à 3,
**caractérisé en ce que** le circuit (4) de liaison est un convertisseur (15) de tension continue ou comprend un convertisseur (15) de tension continue.

10. Dispositif d'accumulation d'énergie suivant l'une des revendications précédentes,
**caractérisé en ce que** le circuit (4) de liaison sépare la batterie (2) galvaniquement de l'élément (3) d'accumulation d'énergie.

11. Dispositif d'accumulation d'énergie suivant l'une des revendications précédentes,
**caractérisé en ce que** plusieurs éléments (3) d'accumulation d'énergie sont montés en parallèle les uns avec les autres.

12. Dispositif d'accumulation d'énergie suivant l'une des revendications précédentes,
**caractérisé en ce que** le dispositif (29) de contrôle de l'état de charge est constitué pour mémoriser plusieurs valeurs de mesure de la tension à distance dans le temps et/ou des états de charge déterminés de la batterie (2) et/ou de l'élément (3) d'accumulation d'énergie et pour en tenir compte dans le calcul de l'état de charge de la batterie (2).

13. Dispositif d'accumulation d'énergie suivant l'une des revendications précédentes,
**caractérisé en ce qu'**il comprend un dispositif de mesure du courant pour mesurer une grandeur de courant réelle du flux de courant passant dans le dispositif (1) d'accumulation d'énergie et/ou la batterie (2) et/ou l'élément (3) d'accumulation d'énergie, le dispositif (29) de contrôle de l'état de charge étant constitué pour prendre en compte la grandeur de courant réelle et/ou pour mémoriser les grandeurs de courant réelles et pour prendre en compte les grandeurs de courant réelles précédentes dans le temps dans le calcul de l'état de charge de la batterie (2) et/ou de l'élément (3) d'accumulation d'énergie.

14. Dispositif d'accumulation d'énergie suivant l'une des revendications précédentes,
**caractérisé en ce que** la tension chutant aux bornes de l'élément (3) d'accumulation d'énergie dépend, pour au moins un domaine des états de charge de l'élément (3) d'accumulation d'énergie, plus fortement de l'état de charge de l'élément (3) d'accumulation d'énergie que la tension chutant aux bornes de la batterie (2), ne dépend de l'état de charge de la batterie (2) dans le domaine de charge équivalent de la batterie (2).

15. Dispositif d'accumulation d'énergie suivant l'une des revendications précédentes,
**caractérisé en ce que** l'autre élément (3) d'accumulation d'énergie est une cellule d'accumulation électrochimique ou un condensateur ou un super condensateur.

16. Dispositif d'accumulation d'énergie suivant la revendication 15,
**caractérisé en ce que** le super condensateur est un condensateur à couche double, un condensateur hybride ou un pseudo condensateur.
